# EUROPEAN PATENT APPLICATION

(11) **EP 4 379 403 A1**
(43) Date of publication of application: **05.06.2024**
(21) Application number: 22847792.3
(22) Date of filing: 20.01.2022
(51) Int. Cl.: G01R 31/28

(54) **TEST APPARATUS**

(30) Priority: 29.07.2021 CN 202110866169
(71) Applicant: HANGZHOU CHANGCHUAN TECHNOLOGY CO., LTD., Hangzhou, Zhejiang 310051 (CN)
(72) Inventor: LIANG, Yuquan, Hangzhou, Zhejiang 310051 (CN); ZHANG, Qijie, Hangzhou, Zhejiang 310051 (CN); QIU, Guozhi, Hangzhou, Zhejiang 310051 (CN)
(74) Representative: Petraz, Gilberto Luigi
(86) International application number: PCT/CN2022/073008
(87) International publication number: WO 2023/005171

(57) **Abstract**

A test apparatus, which is configured for testing an electronic element, and includes a test table (10) and a circuit board (20). The circuit board (20) is electrically connected to the test table (10); the test table (10) is provided with an air-intake hole (14), an air-out hole (15) and a gas flow channel (16); and the gas flow channel (16) is connected to and in communication with the air-intake hole (14) and the air-out hole (15), respectively, so that gas is capable of entering the gas flow channel (16) from the air-intake hole (14), flowing out from the air-out hole (15), and coming into contact with the circuit board (20) so as to control a temperature of the circuit board (20) to be within a range of -10 °C to 100 °C.

## Description

### CROSS-REFERENCE TO RELATED APPLICATIONS

This application claims priority to Chinese patent applications No. 202110866169.5, filed on July 29, 2021, titled "TEST APPARATUS". The content of the above application is hereby incorporated by reference.

### TECHNICAL FIELD

The present invention generally relates to a technical field of testing electronic elements, and in particular, to a test apparatus.

### BACKGROUND

A test temperature of an electronic element, especially a chip, is usually in a range of -55°C to 150°C, so a temperature of a test table which bears the chip is also in a range of -55°C to 150°C. The test table may transfer heat to a circuit board. Meanwhile, a temperature of the circuit board would be in a range of -30°C to 135°C due to a gas leakage in a test base of the test table and other reasons. The circuit board and electronic elements thereof may be damaged by a high temperature. A test device may misjudge the chip as a defective product, which affects accuracy of a test result. The chip may have condensation and frost phenomenon due to a low temperature, and in a serious case, a circuit shorting may be caused and a test machine may be burned.

A relevant way to control the temperature of the circuit board is to set up a heat insulating chamber and vent air into the heat insulating chamber, thus isolating the circuit board from a substrate. However, the temperature of the circuit board cannot be controlled to be greater than or equal to -30°C in a low temperature case.

### SUMMARY

In order to solve the above problem, the present invention provides a test apparatus with the following technical solution:

A test apparatus, which is configured for testing an electronic element, includes a test table and a circuit board, and the circuit board is electrically connected to the test table. The test table is provided with an air-intake hole, an air-out hole, and a gas flow channel. The gas flow channel is connected to and in communication with the air-intake hole and the air-out hole, respectively, so that gas is capable of entering the gas flow channel from the air-intake hole, flowing out from the air-out hole, and coming into contact with the circuit board so as to control a temperature of the circuit board to be within a range of -10 °C to 100 °C.

In this way, the circuit board and the elements on the circuit board may be protected from a high temperature, and life of the circuit board may be extended. At the same time, it may alleviate a problem of low-temperature frost on the circuit board, prevent the circuit board from short-circuiting, and reduce the selection of the circuit board and the elements on the circuit board.

In an embodiment, the test table further includes a bleed air block and a substrate, the bleed air block is disposed in the substrate and disposed separately from the substrate, the gas flow channel is disposed in the bleed air block, and a plurality of air-out holes are defined by the gas flow channel penetrating through an inner wall of the bleed air block.

In this way, the test table may be convenient to process, and the plurality of air-out holes may accelerate temperature control effect for the circuit board.

In an embodiment, the bleed air block includes a plurality of layers along a height direction of the bleed air block.

In this way, the bleed air block may leave room for other parts to be set up.

In an embodiment, the test table further includes a test base which is disposed on the test table and electrically connected to the circuit board, the test table is provided with a groove to allow light to pass through and reach the test base, and the gas flow channel is capable of getting out of the way of the groove.

In this way, a fiber optic light source channel may be left open, and light emitted by an emitting member may smoothly pass through the groove and an optical channel on the test base to test the electronic element.

In an embodiment, the gas flow channel further includes at least a first layer and a second layer, the first layer is disposed proximal to the circuit board with respect to the second layer, and the air-out hole is disposed in the first layer.

In this way, more gas may reach the circuit board and accelerate temperature control for the circuit board.

In an embodiment, the gas flow channel further includes a first channel, a second channel, and a third channel. The air-intake hole in communication with the first channel, the third channel and the first channel are connected to and in communication with each other by the second channel, and the third channel is connected to and in communication with the air-out hole.

In an embodiment, the third channel further includes a first branch, a second branch, and a third branch. An end of the first branch is connected to and in communication with the second channel, and another end of the first branch is connected to and in communication with the second branch and the third branch, respectively. The second branch and the third branch extend along opposite directions, respectively.

In this way, the gas may contact with the circuit board from both sides of the circuit board, and uniformly neutralize the temperature of the circuit board.

In an embodiment, the second branch further includes a first main branch, a first connecting channel, and a first sub-branch. The first main branch is connected to and in communication with the first branch, an end of the first main branch away from the first branch is connected to the first connecting channel, and the first connecting channel extends along a direction proximal to the first channel and is connected to and in communication with the first sub-branch. The third branch further includes a second main branch, a second connecting pipe, and a second sub-branch; the second main branch is connected to and in communication with the first branch, an end of the second main branch away from the first branch is connected to the second connecting channel, and the second connecting channel extends along the direction proximal to the first channel and is connected to and in communication with the second sub-branch.

In this way, the air-out hole may be located at the first layer.

In an embodiment, the test table further includes a substrate, and a heat insulating plate is provided between the substrate and the circuit board.

In this way, the circuit board may be further protected to insulate heat transferred from the substrate to the circuit board.

In an embodiment, the test apparatus further includes a switching valve. The switching valve is connected to a first air source and a second air source, respectively, and is connected to and in communication with the air-intake hole. When the temperature of the circuit board is greater than or equal to a preset temperature denoted as T1, the first air source is in communication with the air-intake hole by the switching valve to decrease the temperature of the circuit board. When the temperature of the circuit board is lower than or equal to a preset temperature denoted as T2, the second air source is in communication with the air-intake hole by the switching valve to increase the temperature of the circuit board.

In this way, it enables switching of different gases so that the gases may not only lower the temperature of the circuit board, but also raise the temperature of the circuit board.

Compared with the related art, in the test apparatus provided in the present invention, the gas flow channel may be provided in the test table, the gas may enter the gas flow channel from the air-intake hole, flow out from the air-out hole, and contact with the circuit board, so as to control the temperature of the circuit board to be within a range of -10 °C to 100 °C. The circuit board and the elements on the circuit board may be protected from effects of the high temperature and the low temperature, and life of the circuit board may be extended. At the same time, the selection of the circuit board and the elements on the circuit board may be reduced.

### BRIEF DESCRIPTION OF THE DRAWINGS

FIG. 1 is a schematic diagram of a test apparatus without a circuit board in the present invention.
FIG. 2 is a partial enlarged diagram of C in FIG. 1.
FIG. 3 is a front diagram of a test apparatus in the present invention.
FIG. 4 is an upward diagram of a test apparatus in the present invention.
FIG. 5 is a left diagram of a bleed air block.
FIG. 6 is a cross-sectional diagram at A-A in FIG. 5.
FIG. 7 is a front diagram of a bleed air block.
FIG. 8 is a cross-sectional diagram at B-B in FIG. 7.
FIG. 9 is a three-dimensional diagram of a bleed air block.
FIG. 10 is a first perspective diagram of a gas flow channel.
FIG. 11 is a second perspective diagram of a gas flow channel.

In the figures, 100 represents a test apparatus, 10 represents a test table, 11 represents a substrate, 111 represents a ventilation hole, 12 represents a test base, 121 represents an optical channel, 13 represents a groove, 14 represents an air-intake hole, 15 represents an air-out hole, 16 represents a gas flow channel, 161 represents a first layer, 162 represents a second layer, 163 represents a first channel, 164 represents a second channel, 165 represents a third channel, 1651 represents a first branch, 1652 represents a second branch, 1652a represents a first main branch, 1652b represents a first connecting channel, 1652c represents a first sub-branch, 1652d represents a third sub-branch, 1653 represents a third branch, 1653a represents a second main branch, 1653b represents a second connecting channel, 1653c represents a second sub-branch, 1653d represents a fourth sub-branch, 17 represents a bleed air block, 18 represents a heat insulating plate, 20 represents a circuit board, 30 represents an electronic element.

### DETAILED DESCRIPTION OF THE EMBODIMENT

The technical solutions in the embodiments of the present invention are clearly and completely described in the following with reference to the accompanying drawings in the embodiments of the present invention. It is obvious that the described embodiments are only a part of the embodiments, but not all of the embodiments. All other embodiments obtained by those skilled in the art based on the embodiments of the present invention without making creative labor are the scope of the present invention.

It should be noted that when an assembly is considered to be "disposed on" another assembly, it can be directly disposed to another assembly, or there can be a centered assembly. When an assembly is considered to be "set on" another assembly, it can be directly set on another assembly, or there can be a centered assembly at the same time. When an assembly is considered to be "fixed to" another assembly, it can be directly fixed to another assembly, or there can be a centered assembly at the same time.

Unless otherwise defined, all technical and scientific terms used herein have the same meaning as a skilled person in the art would understand. The terminology used in the description of the present invention is for the purpose of describing particular embodiments and is not intended to limit the invention. The term "or/and" as used herein includes any and all combinations of one or more of the associated listed items.

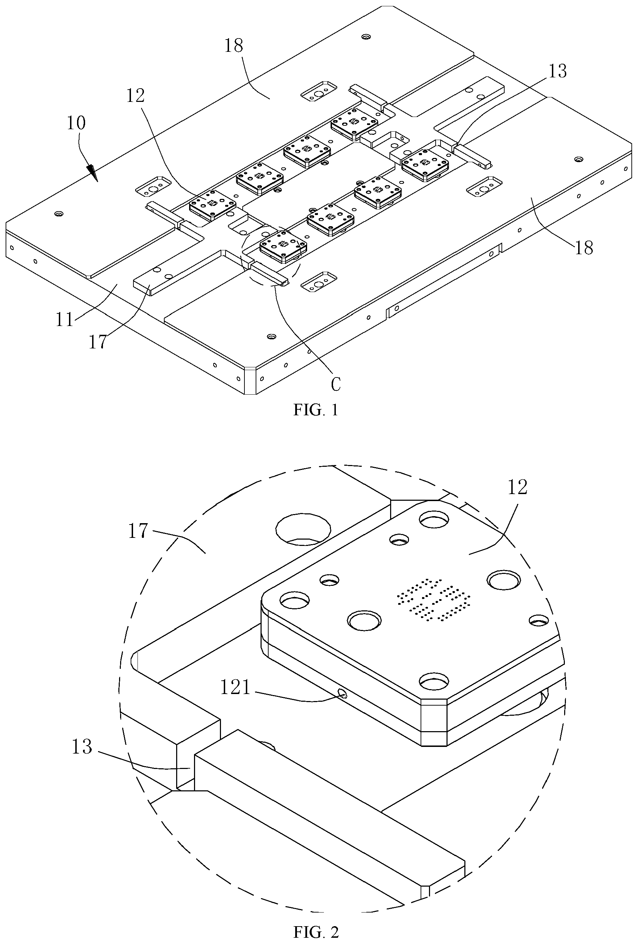

Referring to FIG. 1, FIG. 1 is a schematic diagram of a test apparatus 100 without a circuit board 20 in the present invention. The test apparatus 100 provided in the present invention is configured to test an electronic element 30. In the present embodiment, the electronic element 30 may be a chip. In other embodiments, the electronic element 30 may also be other electronic elements such as a resistor.

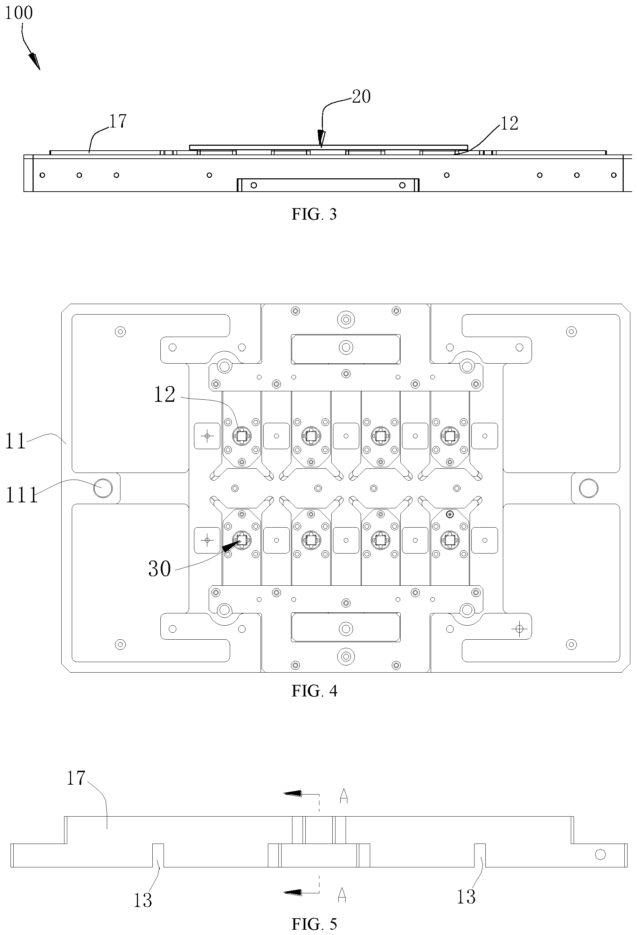

Referring to FIG. 3, FIG. 3 is a front diagram of the test apparatus 100 in the present invention. The test apparatus 100 includes a test table 10 and a circuit board 20, and the circuit board 20 is electrically connected to the test table 10.

Furthermore, the test table 10 may further include a substrate 11 and a test base 12. The test base 12 may be disposed on the substrate 11 and be configured to place and test the electronic element 30. The circuit board 20 may be fixed to and electrically connected to the test base 12.

In the present invention, referring to FIG. 2, FIG. 2 is a partial enlarged diagram of C in FIG. 1. The test table 10 is provided with a groove 13 to allow light to pass through and reach the test base 12, so that it may be detected whether the electronic element 30 in the test base 12 is in a normal placement state. It may be understood that the test base 12 is provided with an optical channel 121, the groove 13 is disposed relative to the optical channel 121, and two sides of the test base 12 are provided with an emitting member (not shown in the drawings) and a light-sensitive member (not shown in the drawings), respectively. The light emitted by the emitting member may pass through the groove 13 and enter the optical channel 121. When the electronic element 30 is placed at an angle or stacked, the light may be blocked by the chip 30 and cannot be sensed by the light-sensitive member, and the electronic element 30 may be not placed properly. In other embodiments, the test table 10 may also not be provided with the groove 13.

In the related art, a test temperature of a chip may be in a range of -55 °C to 150 °C, so a temperature of a substrate and a test base which bear the chip may also be in a range of -55 °C to 150 °C, and the substrate and the test base may transfer heat to a circuit board, i.e., the substrate and the test base may perform heat convection, heat radiation and heat conduction to the circuit board. Meanwhile, a temperature of the circuit board would be in a range of -30°C to 135°C due to a gas leakage in a test base and other reasons. The circuit board and electronic elements thereof may be damaged by a high temperature. A test device may misjudge the chip as a defective product, which affects accuracy of a test result. The chip may have condensation and frost phenomenon due to a low temperature, and in a serious case, a circuit shorting may be caused and a test machine may be burned.

In the present invention, the test table 10 is provided with an air-intake hole 14, an air-out hole 15, and a gas flow channel 16. The gas flow channel 16 is connected to and in communication with the air-intake hole 14 and the air-out hole 15, respectively, so that gas is capable of entering the gas flow channel 16 from the air-intake hole 14, flowing out from the air-out hole 15, and coming into contact with the circuit board 20, so as to reduce effect of heat transfer of the substrate 11 to the circuit board 20 and the gas leakage in the test base 12 to the circuit board 20, thereby controlling the temperature of the circuit board 20 to be within a range of -10 °C to 100 °C. In this way, it may extend life of the circuit board 20 and the electronic element on the circuit board 20 and alleviate a problem of condensation and frost on the circuit board 20. Meanwhile, it may allow for diversity in a selection of the electronic element on the circuit board 20. The gas is capable of controlling the temperature of the circuit board 20 at -10°C, 0°C, 10°C, 20°C, 50°C, 80°C, 90°C, 100°C, or any value between -10°C and 100°C.

In the present invention, the air-out hole 15 may blow towards a gap between the substrate 11 and the circuit board 20. In other embodiments, an axis of the air-out hole 15 may also be perpendicular to the circuit board 20 and the air-out hole 15 may blow directly towards the circuit board 20 according to different designs of structures of the substrate 11, the test base 12, and the circuit board 20.

The gas may include a first air source and a second air source. When the temperature of the circuit board 20 is greater than or equal to a preset temperature denoted as T1, the first air source may be in communication with the air-intake hole 14, and the gas may be blown out from the air-out hole 15, to decrease the temperature of the circuit board 20. When the temperature of the circuit board is lower than or equal to a preset temperature denoted as T2, the second air source may be in communication with the air-intake hole 14, and the gas may be blown out from the air-out hole 15, to increase the temperature of the circuit board 20. The temperature T1 may be 100°C, 90°C, etc. The temperature T2 may be -10°C, 0°C, etc. The temperature T1 and the temperature T2 may be adapted to different application fields.

Alternatively, the first air source may be air with room temperature, which is capable of lowering the temperature of the circuit board 20. The second air source may be a drying gas, which is not only capable of increasing the temperature of the circuit board 20, but also capable of drying the circuit board 20, thereby further preventing the circuit board 20 from condensation and frost. It should be noted that the drying gas in the present invention may be a gas with a dew point temperature below -70°C.

The air with room temperature and the drying gas are capable of controlling a temperature of a control board of the circuit board 20 at a temperature between 0°C to 90°C, thereby further protecting the circuit board 20.

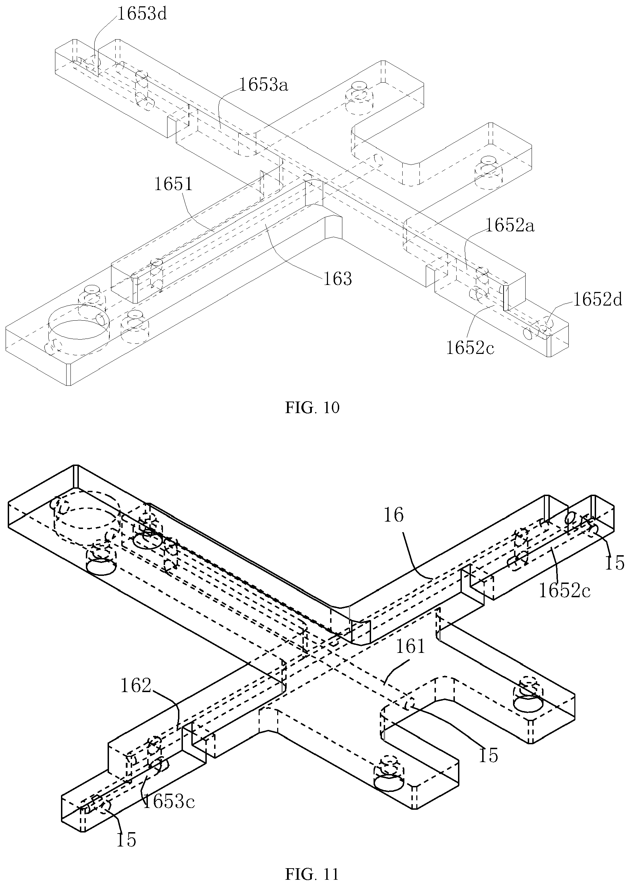

Referring to FIG. 10 and FIG. 11, FIG. 10 is a first perspective diagram of the gas flow channel 16, and FIG. 11 is a second perspective diagram of the gas flow channel 16. The gas flow channel 16 is provided separately along a direction perpendicular to the circuit board 20, so as to get out of the way of the groove 13, give way to the fiber optic light source channel, and avoid blocking the light emitted by the emitting member.

In the present embodiment, the gas flow channel 16 may be divided into an upper layer and a lower layer. In other embodiments, the gas flow channel 16 may also be divided into three and more layers, as long as the gas flow channel 16 is capable of getting out of the way of the groove 13.

Specifically, the gas flow channel 16 may include at least a first layer 161 and a second layer 162, the first layer 161 may be disposed proximal to the circuit board 20 with respect to the second layer 162, and the air-out hole 15 may be disposed in the first layer 161, so that the temperature of the circuit board 20 may be controlled in time.

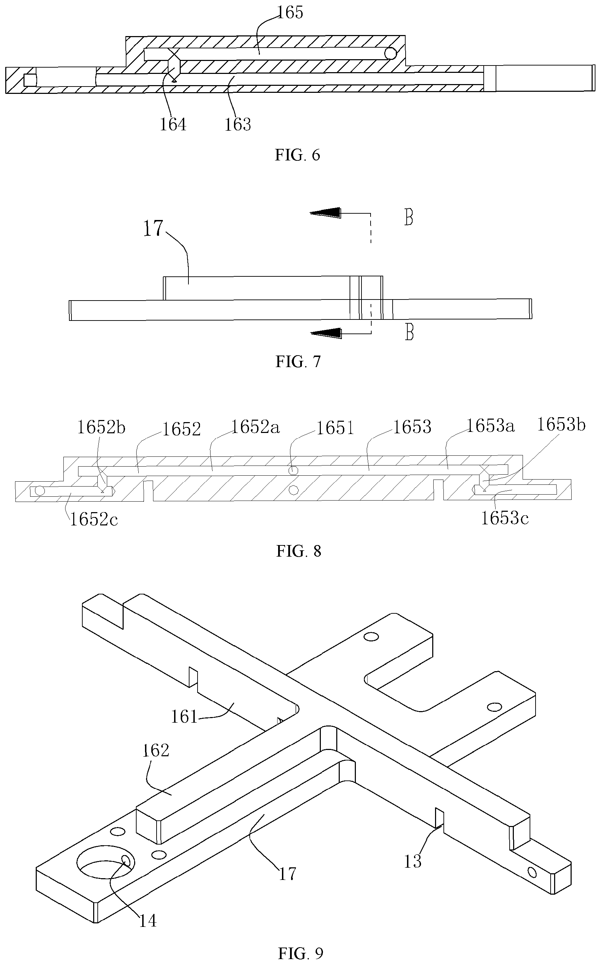

Referring to FIG. 9, FIG. 9 is a three-dimensional diagram of a bleed air block 17. The air-intake hole 14 may also be disposed in the first layer 161 to facilitate processing.

Referring to FIG. 5 and FIG. 6, FIG. 5 is a left diagram of the bleed air block 17, and FIG. 6 is a cross-sectional diagram at A-A in FIG. 5. The gas flow channel 16 may include a first channel 163, a second channel 164, and a third channel 165. The air-intake hole 14 may be in communication with the first channel 163, the third channel 165 and the first channel 163 may be connected to and in communication with each other by the second channel 164, and the third channel 165 may be connected to and in communication with the air-out hole 15.

Referring to FIG. 7 and FIG. 8, FIG. 7 is a front diagram of the bleed air block 17, and FIG. 8 is a cross-sectional diagram at B-B in FIG. 7. The third channel 165 may further include a first branch 1651, a second branch 1652, and a third branch 1653. An end of the first branch 1651 may be connected to and in communication with the second channel 164, and another end of the first branch 1651 may be connected to and in communication with the second branch 1652 and the third branch 1653, respectively. The second branch 1652 and the third branch 1653 may extend along opposite directions, respectively, thereby enabling air to come out in different directions and controlling the temperature of the circuit board 20 multidimensionally.

Furthermore, the second branch 1652 may further include a first main branch 1652a, a first connecting channel 1652b, and a first sub-branch 1652c. The first main branch 1652a may be connected to and in communication with the first branch 1651, an end of the first main branch 1652a away from the first branch 1651 may be connected to the first connecting channel 1652b, and the first connecting channel 1652b may extend along a direction proximal to the first channel 163 and be connected to and in communication with the first sub-branch 1652c. The third branch 1653 may further includes a second main branch 1653a, a second connecting pipe, and a second sub-branch 1653c. The second main branch 1653a may be connected to and in communication with the first branch 1651, an end of the second main branch 1653a away from the first branch 1651 may be connected to the second connecting channel 1653b, and the second connecting channel 1653b may extend along the direction proximal to the first channel 163 and be connected to and in communication with the second sub-branch 1653c, so as to blow air to the first layer 161.

The number of the air-out hole 15 may be more than one, and a plurality of air-out holes 15 can increase the amount of air outlet. In the present embodiment, the number of the air-out hole 15 may be three, one air-out hole 15 may be located at an end of the first channel 163 away from the air-intake hole 14, one air-out hole 15 may be located at an end of the first sub-branch 1652c away from the first connecting channel 1652b, and another air-out hole 15 may be located at an end of the second sub-branch 1653c away from the second connecting channel 1653b. The three air-out holes 15 may not only increase the amount of air outlet, but also uniformly control the temperature of the circuit board 20 from different directions.

Referring to FIG. 10 and FIG. 11, FIG. 10 is a first perspective diagram of the gas flow channel 16, and FIG. 11 is a second perspective diagram of the gas flow channel 16. The second branch 1652 may further include a third sub-branch 1652d, the third sub-branch 1652d may be connected to an end of the first sub-branch 1652c away from the first connecting channel 1652b, an outlet of the third sub-branch 1652d may be the air-out hole 15 and face towards the test base 12. The third branch 1653 may further include a fourth sub-branch 1653d, the fourth sub-branch 1653d may be connected to an end of the second sub-branch 1653c away from the second connecting channel, an outlet of the fourth sub-branch 1653d may be the air-out hole 15 and face towards the test base 12. The third sub-branch 1652d and the fourth sub-branch 1653d can change a blowing direction, thereby allowing more gas to contact with the circuit board 20.

Specifically, the first channel 163 may be parallel to the first branch 1651, the second channel 164 may be perpendicular to the first channel 163 and the first branch 1651, respectively. The first main branch 1652a and the second main branch 1653a may be perpendicular to the first branch 1651, respectively, the first connecting channel 1652b may be perpendicular to the first main branch 1652a, and the second connecting channel 1653b may be perpendicular to the second main branch 1653a. The first sub-branch 1652c may be perpendicular to the first connecting channel 1652b, and the third sub-branch 1652d may be perpendicular to the first sub-branch 1652c. The second sub-branch 1653c may be perpendicular to the second connecting channel 1653b, and the fourth sub-branch 1653d may be perpendicular to the second sub-branch 1653c. The branches are perpendicular or parallel with each other, which can not only change the direction of gas flow, but also facilitate processing.

Furthermore, the test table 10 may further include a bleed air block 17. The bleed air block 17 may be disposed in the substrate 11 and disposed separately from the substrate 11. The gas flow channel 16, the air-out hole 15, and the air-intake hole 14 may be disposed on the bleed air block 17. The gas flow channel 16 may be disposed on the bleed air block 17, and then the bleed air block 17 may be embedded in the substrate 11 to facilitate processing. In other embodiments, the gas flow channel 16 may be disposed in the substrate 11 directly. A plurality of air-out holes 15 may be defined by the gas flow channel 16 penetrating through an inner wall of the bleed air block 17.

Alternatively, the bleed air block 17 may be provided in layers along a height direction of the bleed air block 17, so that the gas flow channel 16 may be provided separately. A length of the bleed air block 17 provided in the second layer 162 may be less than that of the bleed air block 17 provided in the first layer 161, so as to get out of the way of the air-intake hole 14. The groove 13 may be disposed on the bleed air block 17 of the first layer 161. It should be noted that the height direction of the bleed air block 17 refers to a direction perpendicular to the substrate 11.

In the present embodiment, the number of the bleed air block 17 may be two, and two bleed air blocks 17 may disposed at two sides of the test base 12, respectively, thereby uniformly controlling the temperature of the circuit board 20 along a direction proximal to two sides of the circuit board 20. In other embodiments, the number of the bleed air blocks 17 may be three, four, or more, and the bleed air blocks 17 may be disposed around circumference of the test base 12.

Referring to FIG. 4, FIG. 4 is an upward diagram of the test apparatus 100 in the present invention. The substrate 11 is provided with a ventilation hole 111, which is connected to and in communication with the air-intake hole 14.

Specifically, a heat insulating plate 18 is provided between the substrate 11 and the circuit board 20 to further insulate the heat transfer from the substrate 11 to the circuit board 20. Specifically, the heat insulating plate 18 is capable of insulating the heat convection and heat radiation from the substrate 11 to the circuit board 20.

The heat insulating plate 18 may be disposed on the substrate 11 and at two sides of the bleed air blocks 17, getting out of the way of the bleed air blocks 17 and the test base 12.

In the present embodiment, heat insulating plates 18 at the two sides of the bleed air blocks 17 are both provided in three layers, thereby enhancing heat insulation effect. In other embodiments, the heat insulating plate 18 may be provided in one layer, two layers, four layers or more.

In the present embodiment, the heat insulating plate 18 may be fixedly connected to the substrate 11 by a bolt. In other embodiments, a connection between the heat insulating plate 18 and the substrate 11 is not limited to the above-described connection, and the heat insulating plate 18 and the substrate 11 may also be connected by means of snap-fit, riveting, and the like.

Alternatively, material of the heat insulating plate 18 may be epoxy resin, which has good heat resistance and electrical insulation.

The test apparatus 100 may further include a switching valve (not shown in the drawings). The switching valve may be connected to the first air source, the second air source and the ventilation hole 111, respectively. The switching valve is configured to switch two air sources. In the present embodiment, the switching valve may be an electromagnetic valve. In other embodiments, a motorized ball valve, a manual ball valve, or the like may be applied to realize switching.

A throttle valve (not shown in the drawings) may also be provided between the switching valve and the air-out hole 15 for controlling flow of gas.

In an operation of the test apparatus, when the temperature of the circuit board 20 is detected to be greater than a temperature denoted as T, the switching valve may switch to the first air source, the air with room temperature may enter the air-intake hole 14 from the ventilation hole 111, and enter the first channel 163. A part of gas may be blown out from an end of the first channel 163 away from the air-intake hole 14, and another part of gas may enter the second layer 162 from the second channel 164, and enter the first branch 1651 and be split. A split gas may enter the first main branch 1652a, enter the first layer 161 via the first connecting channel 1652b, enter the first sub-branch1652c, and be blown out from the third sub-branch1652d. Another spilt gas may enter the second main branch 1653a, enter the first layer 161 via the second connecting channel 1653b, enter the second sub-branch 1653c, and be blown out from the fourth sub-branch 1653d.

The technical features of the above-mentioned embodiments can be combined arbitrarily. In order to make the description concise, not all possible combinations of the technical features are described in the embodiments. However, as long as there is no contradiction in the combination of these technical features, the combinations should be considered as in the scope of the present invention.

The above-described embodiments are merely illustrative of several embodiments of the present invention, and the description thereof is relatively specific and detailed, but is not to be construed as limiting the scope of the invention. It should be noted that a number of variations and modifications may be made by those skilled in the art without departing from the spirit and scope of the invention. Therefore, the scope of the invention should be determined by the appended claims.

## Claims

1. A test apparatus, which is configured for testing an electronic element, **characterized in that** the test apparatus comprises a test table and a circuit board, and the circuit board is electrically connected to the test table; and
the test table is provided with an air-intake hole, an air-out hole, and a gas flow channel; and the gas flow channel is connected to and in communication with the air-intake hole and the air-out hole, respectively, so that gas is capable of entering the gas flow channel from the air-intake hole, flowing out from the air-out hole, and coming into contact with the circuit board so as to control a temperature of the circuit board to be within a range of -10 °C to 100 °C.

2. The test apparatus of claim 1, wherein the test table further comprises a bleed air block and a substrate, the bleed air block is disposed in the substrate and disposed separately from the substrate, the gas flow channel is disposed in the bleed air block, and a plurality of air-out holes are defined by the gas flow channel penetrating through an inner wall of the bleed air block.

3. The test apparatus of claim 2, wherein the bleed air block comprises a plurality of layers along a height direction of the bleed air block.

4. The test apparatus of claim 1 or claim 2, wherein the test table further comprises a test base which is disposed on the test table and electrically connected to the circuit board, the test table is provided with a groove to allow light to pass through and reach the test base, and the gas flow channel is capable of getting out of the way of the groove.

5. The test apparatus of claim 1, wherein the gas flow channel further comprises at least a first layer and a second layer, the first layer is disposed proximal to the circuit board with respect to the second layer, and the air-out hole is disposed in the first layer.

6. The test apparatus of claim 1, wherein the gas flow channel further comprises a first channel, a second channel, and a third channel; the air-intake hole is in communication with the first channel, the third channel and the first channel are connected to and in communication with each other by the second channel, and the third channel is connected to and in communication with the air-out hole.

7. The test apparatus of claim 6, wherein the third channel further comprises a first branch, a second branch, and a third branch; an end of the first branch is connected to and in communication with the second channel, and another end of the first branch is connected to and in communication with the second branch and the third branch, respectively; and the second branch and the third branch extend along opposite directions, respectively.

8. The test apparatus of claim 6, wherein the second branch further comprises a first main branch, a first connecting channel, and a first sub-branch; the first main branch is connected to and in communication with the first branch, an end of the first main branch away from the first branch is connected to the first connecting channel, and the first connecting channel extends along a direction proximal to the first channel and is connected to and in communication with the first sub-branch; and
the third branch further comprises a second main branch, a second connecting pipe, and a second sub-branch; the second main branch is connected to and in communication with the first branch, an end of the second main branch away from the first branch is connected to the second connecting channel, and the second connecting channel extends along the direction proximal to the first channel and is connected to and in communication with the second sub-branch.

9. The test apparatus of claim 1, wherein the test table further comprises a substrate, and a heat insulating plate is provided between the substrate and the circuit board.

10. The test apparatus of claim 1, further comprising a switching valve, wherein the switching valve is connected to a first air source and a second air source, respectively, and is connected to and in communication with the air-intake hole;
when the temperature of the circuit board is greater than or equal to a preset temperature denoted as T1, the first air source is in communication with the air-intake hole by the switching valve to decrease the temperature of the circuit board; and
when the temperature of the circuit board is lower than or equal to a preset temperature denoted as T2, the second air source is in communication with the air-intake hole by the switching valve to increase the temperature of the circuit board.
